# EUROPÄISCHE PATENTSCHRIFT

(11) **EP 0 920 638 B1**
(45) Veröffentlichungstag und Bekanntmachung des Hinweises auf die Patenterteilung: **12.02.2003**
(21) Anmeldenummer: 97931694.0
(22) Anmeldetag: 01.07.1997
(51) Int. Cl.: G01S 5/14

(54) **VERFAHREN ZUR INITIALISIERUNG EINES EMPFÄNGERS ZUR POSITIONSBESTIMMUNG UND EMPFÄNGER DAZU**
PROCESS FOR INITIALIZING A RECEIVER FOR DETERMINING POSITION AND CORRESPONDING RECEIVER
PROCEDE D'INITIALISATION D'UN RECEPTEUR SERVANT A DETERMINER UNE POSITION ET RECEPTEUR CORRESPONDANT

(30) Priorität: 20.08.1996 DE 19633477
(43) Veröffentlichungstag der Anmeldung: 09.06.1999
(73) Patentinhaber: ROBERT BOSCH GMBH, 70442 Stuttgart (DE)
(72) Erfinder: BODE, Friedrich-Wilhelm, D-31552 Apelern (DE); TANNEBERGER, Volkmar, D-31139 Hildesheim (DE)
(86) Internationale Anmeldenummer: DE9701375
(87) Internationale Veröffentlichungsnummer: WO98008109

(56) Entgegenhaltungen:
- EP-A- 0 635 728
- CARIVEAU B K ET AL: "SATELLITE DATA MANAGEMENT IN DOD NAVSTAR GPS RECEIVERS" NAVIGATION INTO THE 21ST CENTURY, KISSEMMEE, NOVEMBER 29 - DECEMBER 2, 1988, Nr. 1988, 29.November 1988, INSTITUTE OF ELECTRICAL AND ELECTRONICS ENGINEERS, Seiten 134-144, XP000010488
- PATENT ABSTRACTS OF JAPAN vol. 012, no. 396 (P-774), 21.Oktober 1988 & JP 63 138284 A (NISSAN MOTOR CO LTD), 10.Juni 1988,

## Beschreibung

### Stand der Technik

Die Erfindung geht aus von einem Verfahren zur Initialisierung eines Empfängers und einem Empfänger von Positionssignalen nach der Gattung des unabhängigen Anspruchs.

Bei der zunehmenden Verbreitung von Verkehrstelematik und Navigationsgeräten z. B. in Kraftfahrzeugen gewinnt die Ortungsfunktionalität immer mehr an Bedeutung. Verstärkt kommen hierbei Ortungsempfänger, z. b. für das NAVSTAR, Global Positioning System (GPS), zum Einsatz, die durch Laufzeitmessung zu mehreren GPS-Satelliten eine dreidimensionale Positionsbestimmung erlauben. Neben einer möglichst hohen Positionsgenauigkeit und Verfügbarkeit wird für die Empfänger eine möglichst kurze "Time to first fix" (TTFF), d. h. die Zeit, die nach dem Einschalten des Empfängers bis zur ersten Berechnung und Ausgabe einer Position vergeht, gefordert. Gewöhnlich wird die TTFF bei GPS-Empfängern für verschiedene Startmodi spezifiziert. Man unterscheidet dabei zwischen Warm- und Kaltstart. Beim Kaltstart liegen im Empfänger keine aktuellen Systemdaten und Betriebsparameter vor, oder die Daten sind veraltet und stimmen eventuell nicht mehr mit den tatsächlichen Systemdaten bzw. Betriebsparametern überein. Aufgrund der fehlenden Information können im Empfänger nicht die sichtbaren bzw. günstig zu empfangenden Satelliten bestimmt werden, weshalb der Empfänger darauf angewiesen ist, einzelne der 32 in der GPS-Systemspezifikation vorgesehenen Satelliten durchzuprobieren. Dabei wird der Empfänger entsprechend der Anzahl der parallel zur Verfügung stehenden Kanäle mit sogenannten Search-Sets initialisiert, die ein mehr oder weniger geordnetes Durchsuchen der Satelliten ermöglichen. Es ist bekannt, bei einem Achtkanalempfänger pro Search-Set 8 verschiedenen Satellitenkennungen zu verwenden. Dabei werden die Satellitenkennungen, die als PRN-Nummern aufgelistet sind, der Reihenfolge nach durchsucht. Dadurch kann je nach Position des Empfängers eine lange Zeit vergehen, bis ein Satellit gefunden wird, der zur Kommunikation zur Verfügung steht.

Aus der EP 635 728 A1 ist ein Suchverfahren zur Satellitensuche für einen GPS-Empfänger beschrieben. Bei einem Starten der Vorrichtung wird in Abhängigkeit von der letzten Position geraten, in welcher Position sich ein GPS-Satellit befinden könnte. Anschließend wird von dem Empfänger auf mehreren Kanälen gleichzeitig nach Satelliten gesucht.

### Vorteile der Erfindung

Das erfindungsgemäße Verfahren mit den kennzeichnenden Merkmalen des unabhängigen Patentanspruchs hat dem gegenüber den Vorteil, daß eine spezielle Folge von Senderkennungen, ein spezielles Search-Set gewählt wird, das mit hoher Wahrscheinlichkeit einen aktiven und empfangbaren Satelliten enthält. Dabei werden solche Satellitenkennungen für die Suchdurchläufe gewählt, deren Sender sich bekanntermaßen auf nahezu senkrecht aufeinander stehenden Umlaufbahnen bewegen. Durch diese Maßnahme werden schon nach dem ersten Search-Set mit hoher Wahrscheinlichkeit erfolgreich zu empfangende Satelliten gefunden.

Durch die in den Unteransprüchen aufgeführten Maßnahmen ist eine vorteilhafte Weiterbildung und Verbesserung des im unabhängigen Patentanspruch angegebenen Verfahrens möglich.

Besonders vorteilhaft ist es, daß nach dem Auffinden des ersten aktiven Senders die Übertragung der gesamten Senderkenndaten begonnen wird und daß nach vollständiger Übertragung dieser Senderkenndaten die aktuelle Folge von Senderkennungen, die aktuelle Liste der Search-Sets, errechnet wird, die beim nächsten Kaltstart des Empfängers verwendet werden kann. Bei der Berechnung der aktuellen Liste der Search-Sets ist es wiederum vorteilhaft, daß die Bewegungsebenen der Sender nahezu senkrecht aufeinander liegen. So erhöht sich die statistische Wahrscheinlichkeit, daß bei einem Kaltstart möglichst schnell, zu empfangende Sender gefunden werden.

Weiterhin ist es von Vorteil, daß nach dem Auffinden erster empfangbarer Satelliten und der damit verbundenen Reduzierung der Anzahl von frei verfügbaren Empfängerkanälen die Search-Sets auch teilweise geladen und abgearbeitet werden. In diesem Fall werden aus der Liste der Search-Sets eine der Anzahl der Empfängerkanäle entsprechende Zahl von Satellitenkennungen geladen und den freien Empfängerkanälen zugewiesen. Es ist dafür zu sorgen, daß alle Satellitenkennungen in der Reihenfolge, die durch die Liste der Search-Sets festgelegt ist, abgearbeitet werden.

In einem abschließenden Verfahrensschritt wird die Berechnung der Suchfolgen in einem residenten Speicher abgelegt, damit bei der nächsten Initialisierung des Empfängers sofort auf ein erstes, aktualisiertes Search-Set zurückgegriffen werden kann. Das Verfahren hat den Vorteil, daß die Kaltstartzeit, die "Time to first fix"-Zeit verkürzt wird. Dadurch werden die Navigationsdaten des Empfängers nach dem Einschalten schneller verfügbar. Durch die Aktualisierung der Suchdaten ist eine schnelle und problemlose Anpassung des Empfängers an die tatsächlichen Gegebenheiten der Sender möglich. Es ist sehr einfach, auf den Ausfall eines Satellitensenders oder den Austausch eines Satelliten zu reagieren.

Es von Vorteil, daß die im Speicher hinterlegten Daten des Search-Sets nicht nur nach jedem Kaltstart, sondern in vorgegebenen Zeitabständen aktualisiert werden.

Weiterhin ist es möglich, die gespeicherten Daten durch Informationen über Initialposition und letztem verwendeten Satz von Senderkennungen zu erweitern. Dadurch ist eine noch schnellere Initialisierung des Empfängers möglich.

Der erfindungsgemäße Empfänger mit den kennzeichnenden Merkmalen des unabhängigen Patentanspruchs hat den Vorteil, daß eine Liste von Search-Sets im Empfänger abgelegt wird, wobei die Senderkennungen der einzelnen Search-Sets zu Sendern gehören, die sich in nahezu senkrecht aufeinander stehenden Bahnebenen bewegen.

Durch die in den Unteransprüchen aufgeführten Maßnahmen ist eine vorteilhafte Weiterbildung und Verbesserung des im unabhängigen Anspruch angegebenen Empfängers möglich. Es ist von Vorteil, daß der Empfänger Mittel aufweist, die zur Berechnung einer aktuellen Liste von Search-Sets dienen.

Weiterhin ist es von Vorteil, daß im Empfänger die aktuellen Search-Sets gespeichert werden können.

### Zeichnung

Ein Ausführungsbeispiel der Erfindung ist in der Zeichnung dargestellt und in der nachfolgenden Beschreibung näher erläutert. Es zeigt Figur 1 Satellitenbahnen, Figur 2 die Einteilung der Satelliten auf den unterschiedlichen Bahnen, Figur 3 die Kennung der Satelliten, Figur 4 der Ablauf des erfindungsgemäßen Verfahrens und Fig.5 einen erfindungsgemäßen Empfänger.

### Beschreibung des Ausführungsbeispiels

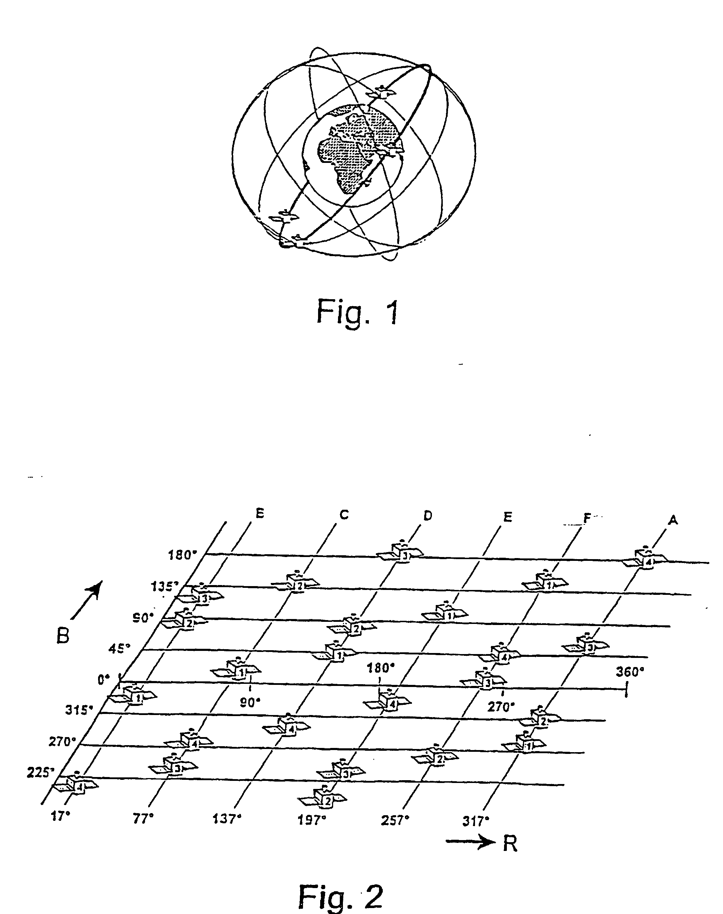

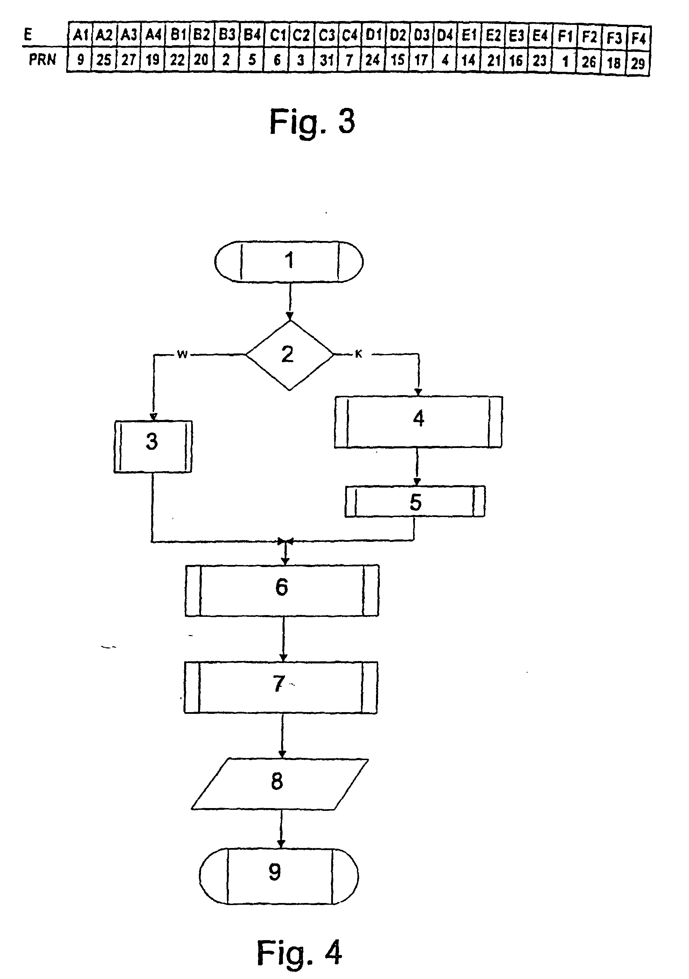

Ein bevorzugtes Ausführungsbeispiel verwendet zur Positionsbestimmung die NAVSTAR GPS-Satelliten. Figur 1 zeigt den Verlauf der Bahnen, auf denen jeweils vier Satelliten positioniert sind. Es stehen bei NAVSTAR somit 24 Satelliten aktuell als Sender zur Verfügung. Figur 2 zeigt die aktuelle Verteilung der Satelliten auf den jeweiligen Satellitenbahnen A bis F im Juni 1996. Die jeweils vier Satelliten befinden sich auf einer Umlaufbahn, deren Ebene um 60° gegenüber der Äquatorebene geneigt ist. Der Winkel zwischen den einzelnen Ebenen beträgt ebenfalls 60° und ist über der R-Achse aufgetragen. Die einzelnen Satelliten können nach Figur 3 durch ihren unterschiedlichen PRN-Code im Empfänger identifiziert werden. Für den Kaltstart nach dem erfindungsgemäßen Verfahren wählt man aus den PRN-Nummern für die Search-Sets möglichst senkrecht aufeinander stehende Ebenen und dabei sämtliche Satelliten dieser Ebene aus. So hat man auch, ohne Kenntnis der Initialposition, an jedem Punkt der Erde die größtmögliche Wahrscheinlichkeit, mindestens einen sichtbaren Satelliten dieses Sets zu empfangen. Für einen Achtkanalempfänger könnte das erste Search-Set z. B. aus Satelliten der Ebene C und A, das zweite Search-Set aus den Satelliten der Ebene B und D und das dritte Search-Set aus den Satelliten der Ebene E und F bestehen.

Eine typische Initialisierung nach dem erfindungsgemäßen Verfahren wird in Figur 4 dargestellt. Nach dem Einschalten des GPS-Empfängers 1 beginnt der Startmodus 2. Hier muß zunächst unterschieden werden, ob ein Warmstart W oder ein Kaltstart K vorliegt. Nach einem Warmstart kann der Empfänger aufgrund der Betriebsparameter gezielt auf die Suche nach Satelliten gehen, was aber nicht den Gegenstand der Erfindung betrifft. Nach dem Kaltstart K befinden sich keine aktuellen Betriebsparameter, und aktuelle Satellitenkennungen im Speicher. Daher liest der Empfänger aus seinem residenten Speicher ein erstes nach dem erfindungsgemäßen Verfahren aufgebautes Search-Set 4 aus. Mit Hilfe des ersten Search-Set 4, das bei einem Achtkanalempfänger aus acht PRN-Nummern von möglichen Satellitensendern besteht, beginnt die Suche 5 nach einem Satelliten, der für den Empfänger sichtbar ist. Sobald der Empfänger das Signal des ersten Satelliten empfangen hat, beginnt er mit der Abfrage der aktuellen Almanach-Daten 6. Die Almanach-Daten enthalten alle aktuellen Bahn- und Betriebsparameter der aktiven Satelliten. Der erste aktive Satellit überträgt an den Empfänger fünf Datenrahmen, wovon die ersten drei Datenrahmen Informationen über Position, Absolutzeit usw. enthalten. Im vierten Datenrahmen wird der Almanach übertragen. Die Informationen über die einzelnen Satelliten werden in fünf Unterrahmen übertragen, wobei die Übertragungsrate 50 Baud beträgt. Die Übertragung der Daten für insgesamt 32 mögliche Satellitenkennungen, von denen entsprechend der Systemspezifikation im Regelfall 24 Satellitenkennungen den aktiven Satelliten zugewiesen sind, benötigt maximal 12,5 Minuten. Aus dem Almanach berechnet der Empfänger anschließend die aktuelle Belegung der verschiedenen Bahnebenen durch die Satelliten, und generiert nach dem erfindungsgemäßen Verfahren die Liste der gültige Search-Sets 7.

Nach der Berechnung der aktuellen Search-Sets aus den aktuellen Almanach-Daten werden die so berechnete Sets im residenten Speicher 8 abgelegt. Der Empfänger beginnt nun seinen stationären Betrieb 9 bis zum Abschalten. Die aktuellen Daten müssen während des Betriebs des Empfängers nicht aktualisiert werden. Erst beim nächsten Kaltstart werden die Search-Sets anhand des aktuellen Almanachs der Satelliten aktualisiert. Eine weitere Ausführungsform ermöglicht es, eine zyklische Wiederholung der Berechnung für Search-Sets, z. B. alle 24 Stunden durchzuführen. Damit auch für GPS-Empfänger im Dauerbetrieb die Generierung von aktuellen adaptiven Search-Sets sichergestellt. Zusätzlich zu der hier dargelegten Berechnung und residenten Speicherung von Search-Sets ist auch die residente Speicherung von Initialposition und Almanach aus dem jeweils letzten Betrieb mit Ausgabe der Navigationsdaten des GPS-Empfängers denkbar. In diesem Fall können bei einem späteren. Kaltstart nach Empfang des ersten Satelliten sofort benachbarte Satelliten aus dem resident gespeicherten Almanach berechnet und eine gezielte Suche gestartet werden. Mit einer solchen Ausführungsform wird die lange Aquisitionsphase der Übertragung des Almanachs abgekürzt. Nach einer längeren Betriebspause besteht in diesem Fall jedoch die Möglichkeit, daß der Almanach mehr oder weniger veraltet ist. Daher müssen Entscheidungskriterien für die Verwendung alter Almanach-Daten berücksichtigt werden.
Ein Kriterium ist z.B. der Zeitraum, indem der Empfänger nicht aktiv war. Man kann sich vorstellen, daß innerhalb eines Tages oder einer Woche auf die Betriebsdaten, nach dieser Zeit auf die gespeicherten Search-Sets zugegriffen werden wird.

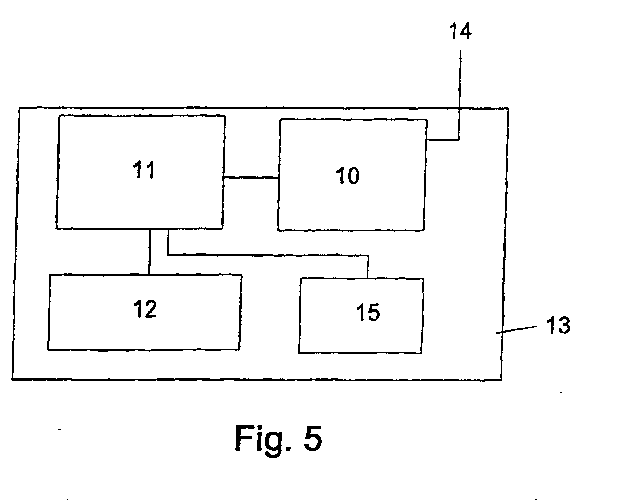

Nach Fig. 5 empfängt der Empfänger 13 Signale 14 der Satelliten. Die Empfangseinheit 10 gibt die Signale an eine Auswerteeinheit 11 weiter. Dort werden die aktuellen Search-Sets berechnet und im Speicher 12 abgelegt. Bei einem Neustart kann auf die Folgen von Kennungen im Speicher 12 zurückgegriffen werden. Die Ergebnisse der Positionsbestimmung, die von der Auswerteeinheit berechnet werden, können grafisch ausgegeben 15 werden oder gehen zur weiteren Verarbeitung in ein Navigationssystem ein. Es ist auch eine Ausgestaltung des Verfahrens denkbar, mit dem Informationen des Almanach bereits genutzt werden, während der Almanach noch übertragen wird. Werden z.B. Bahndaten eines benachbarten Satelliten zu einem bereits empfangenen Satelliten frühzeitig empfangen, so kann mit einem Empfängerkanal mit der gezielten Suche nach diesem Satelliten begonnen werden, während mit den restlichen Empfangskanälen weiterhin mit der durch die Search-Sets festgelegten Reihenfolgen gesucht wird.

## Patentansprüche

1. Verfahren zur Initialisierung eines Empfängers (13) für ein satellitengestütztes Ortungssystem, bei dem der Empfänger über Laufzeitmessungen zu verschiedenen Satelliten eine dreidimensionale Positionsbestimmung durchführt, wobei sich die Satelliten auf Umlaufbahnen um die Erde befinden, **dadurch gekennzeichnet, daß** jede Umlaufbahn eine Ebene definiert, in der die Umlaufbahn liegt, daß für die Suche nach einem ersten Satelliten eine Folge von Senderkennungen von Satelliten, die im Empfänger gespeichert ist, vom Empfänger ausgewählt wird, daß alle Satelliten von mindestens zwei Umlaufbahnen ausgewählt werden, und dass die beiden Ebenen, die durch die Umlaufbahnen definiert werden, Winkel einschließen, die in einem Bereich von 80 bis 100 Grad liegen.

2. Verfahren zur Initialisierung nach Anspruch 1, **dadurch gekennzeichnet, daß** der Winkel zwischen den Ebenen vorzugsweise 90 Grad beträgt.

3. Verfahren zur Initialisierung nach einem der vorhergehenden Ansprüche, **dadurch gekennzeichnet, daß** bei erfolgloser Suche mit der ersten Folge von Senderkennungen eine neue Folge von Senderkennungen ausgewählt wird, bei der bisher noch nicht durchsuchte Bahnen ausgewählt werden.

4. Verfahren zur Initialisierung nach einem der vorhergehenden Ansprüche, **dadurch gekennzeichnet, daß** nach Auffinden des ersten zu empfangenden Senders zunächst aktuelle Senderkennungen und -daten aller anderen Sender übertragen werden, und anschließend daraus aktuelle Folgen von Senderkennungen berechnet und in einem Speicher abgelegt werden.

5. Verfahren zur Initialisierung Anspruch 5, **dadurch gekennzeichnet, daß** eine Wiederholung der Berechnung und Speicherung der aktuellen Folgen von Senderkennungen in einem vorgebbaren Zeitintervall erfolgt.

6. Verfahren zur Initialisierung nach einem der Ansprüche 4-5, **dadurch gekennzeichnet, daß** zusätzlich zu den aktuellen Folgen von Senderkennungen die Positionen der Satelliten zum Zeitpunkt des Speicherns im Empfänger gespeichert werden.

7. Verfahren zur Initialisierung nach einem der vorhergehenden Ansprüche, **dadurch gekennzeichnet, daß** bei einem Empfänger, in dem bereits zu einem früheren Zeitpunkt Positionsdaten von Satelliten gespeichert wurden, nach vorgebbaren Kriterien entweder auf Folgen von Senderkennungen oder auf die Positionen der Satelliten zum Zeitpunkt des Speicherns zugegriffen wird.

8. Verfahren zur Initialisierung nach einem der vorhergehenden Ansprüche, **dadurch gekennzeichnet, daß** im Empfänger die Folgen mit allen zur Verfügung stehenden Empfängerkanälen oder mit einem Teil der zur Verfügung stehenden Empfängerkanälen abgearbeitet werden.

9. Satellitensignalempfänger (13) für ein satellitengestütztes Ortungssystem, mit einer Auswerteeinheit (11) und mit einem nichtflüchtigen Speicher (12), wobei der Satellitensignalempfänger (13) über Laufzeitmessungen zu verschiedenen Satelliten eine dreidimensionale Positionsbestimmung durchführt, wobei sich die Satelliten auf Umlaufbahnen um die Erde befinden, **dadurch gekennzeichnet, dass** jede Umlaufbahn eine Ebene definiert, in der die Umlaufbahn liegt, dass für die Suche nach einem ersten Satelliten eine Folge von Senderkennungen von Satelliten von dem Empfänger ausgewählt wird, dass mehrere Folgen von Senderkennungen in dem nichtflüchtigen Speicher (12) in dem Empfänger gespeichert sind, dass alle Satelliten von mindestens zwei Umlaufbahnen ausgewählt werden und dass die beiden Ebenen, die durch die Umlaufbahnen definiert werden, Winkel einschließen, die in einem Bereich von 80 Grad bis 100 Grad liegen.

## Claims

1. Method for initializing a receiver (13) for a satellite-supported position-finding system, in which the receiver carries out three-dimensional position finding using delay time measurement for various satellites, with satellites being located in orbits around the earth, **characterized in that** each orbit defines a plane in which the orbit is located, **in that** a sequence of transmitter identifiers for satellites which is stored in the receiver is selected by the receiver in order to search for a first satellite, **in that** all the satellites are selected by at least two orbits, and **in that** the two planes which are defined by the orbits include angles which lie in a range from 80 to 100°.

2. Method for initialization according to Claim 1, **characterized in that** the angle between the planes is preferably 90°.

3. Method for initialization according to one of the preceding claims, **characterized in that**, if the search with the first sequence of transmitter identifiers is unsuccessful, a new sequence of transmitter identifiers is selected, using which orbits which have not yet been searched through are selected.

4. Method for initialization according to one of the preceding claims, **characterized in that**, after finding the first transmitter to be received, current transmitter identifiers and data for all the other transmitters are first of all transmitted and, after this, current sequences of transmitter identifiers are calculated and are stored in a memory.

5. Method for initialization according to Claim 5, **characterized in that** repetition of the calculation and storage of the current sequences of transmitter identifiers are carried out at a time interval which can be predetermined.

6. Method for initialization according to one of Claims 4-5, **characterized in that**, in addition to the current sequences of transmitter identifiers, the positions of the satellites at the time of storage are stored in the receiver.

7. Method for initialization according to one of the preceding claims, **characterized in that**, in the receiver in which position data for satellites has already been stored at an earlier time, either sequences of transmitter identifiers or the positions of the satellites at the time of storage are accessed on the basis of criteria which can be predetermined.

8. Method for initialization according to one of the preceding claims, **characterized in that** the sequences are processed in the receiver using all the available receiver channels or using some of the available receiver channels.

9. Satellite signal receiver (13) for a satellite-supported position-finding system, having an evaluation unit (11) and having a nonvolatile memory (12), with the satellite signal receiver (13) carrying out three-dimensional position finding using delay time measurements for various satellites, with the satellites being located on orbits around the earth, **characterized in that** each orbit defines a plane in which the orbit is located, **in that** a sequence of transmitter identifiers of satellites is selected by the receiver in order to search for a first satellite, **in that** a number of sequences of transmitter identifiers are stored in the nonvolatile memory (12) in the receiver, **in that** all the satellites from at least two orbits are selected, and **in that** the two planes which are defined by the orbits include angles which lie in a range from 80° to 100°.

## Revendications

1. Procédé d'initialisation d'un récepteur (13) d'un système de localisation assisté par satellite selon lequel le récepteur effectue par des mesures de temps de parcours vers différents satellites, une détermination de position, en trois dimensions,
les satellites se trouvant sur une orbite autour de la terre,
**caractérisé en ce que**
chaque orbite définit un plan dans lequel se situe l'orbite,
et pour la recherche d'un premier satellite, le récepteur sélectionne une suite de caractéristiques d'émetteur des satellites, caractéristiques mémorisées dans le récepteur,
il sélectionne tous les satellites d'au moins deux orbites, et
les deux plans définis par les orbites font entre eux un angle compris dans une plage de 80 à 100°.

2. Procédé d'initialisation selon la revendication 1,
**caractérisé en ce que**
l'angle entre les plans est notamment égal à 90°.

3. Procédé d'initialisation selon l'une quelconque des revendications précédentes,
**caractérisé en ce qu'**
en cas de recherche réussie avec la première suite de caractéristiques d'émetteur, on sélectionne une nouvelle suite de caractéristiques d'émetteur pour laquelle on sélectionne des trajectoires non encore examinées.

4. Procédé d'initialisation selon l'une quelconque des revendications précédentes,
**caractérisé en ce qu'**
après la recherche du premier émetteur à recevoir, on transmet tout d'abord les caractéristiques et données d'émetteur, actuelles de tous les autres émetteurs et ensuite on calcule à partir de là les suites actuelles de caractéristiques d'émetteur et on les enregistre dans une mémoire.

5. Procédé d'initialisation selon la revendication 4,
**caractérisé en ce qu'**
on répète le calcul et la mémorisation des suites actuelles de caractéristiques d'émetteur dans un intervalle de temps prédéterminé.

6. Procédé d'initialisation selon l'une quelconque des revendications 4 à 5,
**caractérisé en ce qu'**
en plus des suites actuelles de caractéristiques d'émetteur, on mémorise les positions des satellites à l'instant de la mémorisation dans le récepteur.

7. Procédé d'initialisation selon l'une quelconque des revendications précédentes,
**caractérisé en ce que**
pour un récepteur dans lequel on a enregistré déjà un instant précédent, les données de position des satellites, en procédant selon les critères prédéterminés, on accède soit à des suites de caractéristiques d'émetteur, soit aux positions des satellites à l'instant de la mise en mémoire.

8. Procédé d'initialisation selon l'une quelconque des revendications précédentes,
**caractérisé en ce qu'**
dans le récepteur on traite les suites avec tous les canaux de réception disponibles ou avec une partie des canaux de réception disponibles.

9. Récepteur de signaux de satellite (13) pour un système de localisation assisté par satellite, comprenant une unité d'exploitation (11) et une mémoire non volatile (12),
le récepteur de signaux de satellite (13) effectuant par une mesure de temps de parcours avec différents satellites, une détermination de position en trois dimensions,
les satellites se trouvant sur des orbites autour de la terre,
**caractérisé en ce que**
chaque orbite définit un plan dans lequel elle se situe,
pour la recherche d'un premier satellite, le récepteur sélectionne une suite de caractéristiques d'émetteur de satellite,
plusieurs suites de caractéristiques d'émetteur sont mises en mémoire dans la mémoire non volatile (12) du récepteur,
on sélectionne tous les satellites d'au moins deux orbites et les deux plans définis par les orbites font entre eux un angle situé dans une plage comprise entre 80 et 100°.
